# EUROPEAN PATENT APPLICATION

(11) **EP 4 465 786 A1**
(43) Date of publication of application: **20.11.2024**
(21) Application number: 23915486.7
(22) Date of filing: 08.05.2023
(51) Int. Cl.: H10B 12/00

(54) **SEMICONDUCTOR STRUCTURE AND MANUFACTURING METHOD THEREFOR**

(30) Priority: 13.01.2023 CN 202310070761
(71) Applicant: CXMT Corporation, Hefei City, Anhui Province 230601 (CN)
(72) Inventor: LIU, Xiang, Hefei, Anhui 230601 (CN)
(74) Representative: Gulde & Partner
(86) International application number: PCT/CN2023/092777
(87) International publication number: WO 2024/148722

(57) **Abstract**

The disclosure provides a semiconductor structure and a method for manufacturing the same. The semiconductor structure includes a substrate, an active pillar, a bit line, and a trench isolation structure. The trench isolation structure is located in the substrate, and includes a first trench isolation structure and a second trench isolation structure. The first trench isolation structure is exposed by a first surface and a second surface, and the second trench isolation structure is exposed by the first surface. The active pillar is defined by the first trench isolation structure and the second trench isolation structure, a first end of the active pillar is exposed by the first surface, and a second end of the active pillar is connected to the bit line. The bit line is defined by the first trench isolation structure, and is exposed by the second surface. The disclosure can effectively reduce difficulty in alignment between the active pillar and the bit line, and improve precision of alignment between the active pillar and the bit line.

## Description

### CROSS-REFERENCE TO RELATED APPLICATIONS

The disclosure claims priority to Chinese Patent Application No. 202310070761.3, filed with the China National Intellectual Property Administration on January 13, 2023 and entitled "SEMICONDUCTOR STRUCTURE AND METHOD FOR MANUFACTURING SAME", which is incorporated herein by reference in its entirety.

### TECHNICAL FIELD

The disclosure relates to the field of semiconductor technologies, and in particular, to a semiconductor structure and a method for manufacturing the same.

### BACKGROUND

A dynamic random access memory (DRAM) is a semiconductor memory into which data is written or from which data is read randomly at a high speed, and is widely applied to data storage devices or apparatuses.

The DRAM includes multiple storage cells, and each storage cell includes a transistor and a capacitor. A source of the transistor is connected to a bit line, a drain of the transistor is connected to the capacitor, and a gate of the transistor is connected to a word line. Under control of the word line, the transistor writes data information on the bit line into the capacitor, or reads data information stored in the capacitor through the bit line. A part of the transistor is formed in a substrate of the DRAM, an active region is formed in the substrate through doping, and a source region, a channel, and a drain region are formed at different positions of the active region. The channel corresponds to the gate, and a gate dielectric layer is disposed between the channel and the gate.

However, as an integration degree of the DRAM increases, difficulty in alignment between the source and the bit line increases, precision of alignment decreases, and storage performance of the DRAM is affected.

### SUMMARY

The disclosure provides a semiconductor structure and a method for manufacturing the same, which can effectively reduce difficulty in alignment between an active pillar and a bit line, improve precision of alignment between the active pillar and the bit line, and help improve storage performance of a memory having the semiconductor structure.

According to one aspect, the disclosure provides a semiconductor structure, which includes a substrate, an active pillar, a bit line, and a trench isolation structure. The substrate has a first surface and a second surface that are opposite to each other. The trench isolation structure is located in the substrate, the trench isolation structure includes a first trench isolation structure and a second trench isolation structure that extend from the first surface to the second surface, the first trench isolation structure is exposed by the first surface and the second surface, and the second trench isolation structure is exposed by the first surface. The active pillar is defined by the first trench isolation structure and the second trench isolation structure, a first end of the active pillar is exposed by the first surface, a second end of the active pillar is opposite to the first end, and the second end is connected to the bit line. The bit line is defined by the first trench isolation structure, a plane extension direction of the bit line is the same as a plane extension direction of the first trench isolation structure, and the bit line is exposed by the second surface.

According to another aspect, the disclosure provides a method for manufacturing a semiconductor structure, which includes: providing a substrate, where the substrate has a first initial surface and a second initial surface that are opposite to each other; processing the substrate from the first initial surface, to form an active pillar, a first trench and a second trench that define the active pillar, and an initial trench isolation structure filling the first trench and the second trench in the substrate, where a plane extension direction of the first trench and a plane extension direction of the second trench are intersected with each other, a depth of the second trench is less than a depth of the first trench, and the first initial surface serves as a first surface of the substrate; thinning the substrate from the second initial surface, until the initial trench isolation structure in the first trench is exposed, where a surface, opposite to the first surface, of the thinned substrate serves as a second surface of the substrate; etching the substrate from the second surface, to form a third trench, where a plane extension direction of the third trench is the same as the plane extension direction of the first trench; and forming a bit line in the third trench, where the bit line is connected to an end portion of the active pillar close to the second surface, and the bit line is defined by the initial trench isolation structure located in the first trench.

According to the semiconductor structure and the method for manufacturing the same provided in the disclosure, the trench isolation structure is disposed in the substrate, the active pillar is defined by the first trench isolation structure and the second trench isolation structure of the trench isolation structure, the first end of the active pillar is exposed by the first surface of the substrate, the second end of the active pillar is opposite to the first end, and the second end is connected to the bit line. The bit line is defined by the first trench isolation structure, the plane extension direction of the bit line is the same as the plane extension direction of the first trench isolation structure, and the bit line is exposed by the second surface. In this way, both the bit line and the active pillar may be defined by the first trench isolation structure, so as to reduce difficulty in alignment between the active pillar and the bit line, and improve precision of alignment between the active pillar and the bit line. In addition, the foregoing structure helps reduce parasitic capacitance of the bit line and manufacturing difficulty of the bit line, reduce contact resistance at a joint of the bit line and the active pillar, and improve stability of signal transmission on the bit line, thereby helping improve storage performance of a memory having the semiconductor structure.

### BRIEF DESCRIPTION OF DRAWINGS

FIG. 1 is a schematic structural diagram of a bit line, a word line, and an active pillar of a semiconductor structure in a related art;
FIG. 2 is a schematic flowchart of a method for manufacturing a semiconductor structure according to an embodiment of the disclosure;
FIG. 3 is a schematic structural diagram of forming a first isolation layer in a substrate of a semiconductor structure according to an embodiment of the disclosure;
FIG. 4 is a schematic structural diagram of forming a first isolation layer and a second isolation layer in a substrate of a semiconductor structure according to an embodiment of the disclosure;
FIG. 5 is a schematic structural diagram of forming an active pillar in a substrate of a semiconductor structure according to an embodiment of the disclosure;
FIG. 6 is a schematic structural diagram of an active pillar of a semiconductor structure according to an embodiment of the disclosure;
FIG. 7 is a schematic structural diagram of another active pillar of a semiconductor structure according to an embodiment of the disclosure;
FIG. 8 is a cross-sectional view of forming an active pillar in a substrate of a semiconductor structure according to an embodiment of the disclosure;
FIG. 9 is a cross-sectional view of forming a storage structure and an auxiliary substrate on a substrate of a semiconductor structure according to an embodiment of the disclosure;
FIG. 10 is a schematic structural diagram of a semiconductor structure with a substrate flipped over according to an embodiment of the disclosure;
FIG. 11 is a cross-sectional view of a semiconductor structure with a substrate flipped over according to an embodiment of the disclosure;
FIG. 12 is a schematic structural diagram of a semiconductor structure with a substrate thinned according to an embodiment of the disclosure;
FIG. 13 is a cross-sectional view of a semiconductor structure with a substrate thinned according to an embodiment of the disclosure;
FIG. 14 is a schematic structural diagram of forming a third trench in a semiconductor structure according to an embodiment of the disclosure;
FIG. 15 is a cross-sectional view of forming a third trench in a semiconductor structure according to an embodiment of the disclosure;
FIG. 16 is a schematic structural diagram of forming a contact material in a semiconductor structure according to an embodiment of the disclosure;
FIG. 17 is a cross-sectional view of forming a contact material in a semiconductor structure according to an embodiment of the disclosure;
FIG. 18 is a schematic structural diagram of forming a bit line contact structure in a semiconductor structure according to an embodiment of the disclosure;
FIG. 19 is a cross-sectional view of forming a bit line contact structure in a semiconductor structure according to an embodiment of the disclosure;
FIG. 20 is a schematic structural diagram of forming a bit line material in a semiconductor structure according to an embodiment of the disclosure;
FIG. 21 is a schematic structural diagram of forming a bit line in a semiconductor structure according to an embodiment of the disclosure;
FIG. 22 is a cross-sectional view of forming a bit line in a semiconductor structure according to an embodiment of the disclosure;
FIG. 23 is a schematic structural diagram of a memory array formed based on a semiconductor structure according to an embodiment of the disclosure;
FIG. 24 is a partially enlarged view of a portion B in FIG. 23; and
FIG. 25 is a schematic structural diagram of a bit line and an active pillar of a semiconductor structure according to an embodiment of the disclosure.

### DESCRIPTION OF EMBODIMENTS

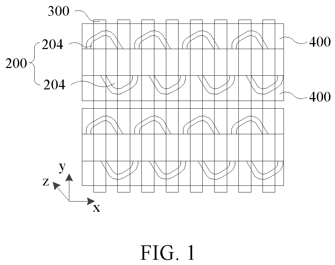

Some transistors of a DRAM device are located in a substrate, an active region is formed in the substrate through doping, and the active region includes a source region, a channel, and a drain region. The source region is connected to a bit line, the channel corresponds to a word line, and the drain region is connected to a capacitor. Conduction and cutoff of the channel are controlled through the word line, to implement a process of storing a signal in the capacitor or reading a signal from a memory with the bit line. FIG. 1 is a schematic structural diagram of a bit line, a word line, and an active pillar of a semiconductor structure in a related art. As shown in FIG. 1, active pillars 200 in the related art are arranged in a hexagonal close-packed form. In this way, capacitor arrangement density in the DRAM device can be improved.

An extension direction of a word line 400 and an extension direction of a bit line 300 are intersected with each other, and an included angle between the word line 400 and the bit line 300 may be a right angle. To be specific, word lines 400 may extend in a direction x in FIG. 1, and are arranged at intervals in a direction y; and bit lines 300 extend in the direction y, and are arranged at intervals in the direction x. An extension direction of the active pillar 200 is a direction z, and there is an included angle of less than 90 degrees between the direction z and the direction y. In the arrangement manner in FIG. 1, one active pillar 200 has two storage node contacts 204 (SNC), and the two storage node contacts 204 are disconnected from each other and have a cut (AA Cut). Each storage node contact is correspondingly connected to one capacitor. In the structure shown in FIG. 1, two adjacent bit lines 300 are respectively connected to two storage node contacts 204 formed by breaking off one active pillar 200. In the foregoing structure, there are problems as follows.
1. There is relatively large difficulty in alignment between the bit line and the storage node contact. Two adjacent bit lines are connected to two storage node contacts formed by breaking off the same active pillar, and a requirement on precision of alignment is relatively high. Consequently, there is a contact deviation between the bit line and the storage node contact. In addition, arrangement of the two bit lines is also affected, and the adj acent bit lines are easily short-circuited.
2. Because the two storage node contacts formed by breaking off the same active pillar are connected to different bit lines, the depth of a cut between the two storage node contacts is large enough, to ensure that the two storage node contacts are completely disconnected. This increases difficulty in a manufacturing process of the DRAM device.
3. Limited by alignment and connection between the bit line and the storage node contact, the width of the bit line is set to be relatively small. In this way, parasitic capacitance of the bit line and manufacturing difficulty thereof are increased. In addition, contact resistance between the bit line and the storage node contact is relatively large, affects signal transmission on the bit line, and subsequently affects storage performance of the DRAM device.

Based on the foregoing technical problems, the disclosure provides a semiconductor structure and a method for manufacturing the same. In the semiconductor structure, a trench isolation structure is disposed in a substrate, an active pillar is defined by a first trench isolation structure and a second trench isolation structure of the trench isolation structure, a first end of the active pillar is exposed by a first surface of the substrate, a second end of the active pillar is opposite to the first end, and the second end is connected to a bit line. The bit line is defined by the first trench isolation structure, a plane extension direction of the bit line is the same as a plane extension direction of the first trench isolation structure, and the bit line is exposed by a second surface. In this way, both the bit line and the active pillar may be defined by the first trench isolation structure, to reduce difficulty in alignment between the active pillar and the bit line, and improve precision of alignment between the active pillar and the bit line. In addition, the foregoing structure helps reduce parasitic capacitance of the bit line and manufacturing difficulty, reduce contact resistance at a joint of the bit line and the active pillar, and improve stability of signal transmission on the bit line, thereby helping improve storage performance of a memory having the semiconductor structure.

To make the objectives, technical solutions, and advantages of the disclosure clearer, the following describes the technical solutions in the embodiments of the disclosure in more detail with reference to the accompanying drawings in the preferred embodiments of the disclosure. In the accompanying drawings, the same or similar reference numerals always represent the same or similar parts or parts having the same or similar functions. The described embodiments are some rather than all of the embodiments of the disclosure. The embodiments described below with reference to the accompanying drawings are examples, are intended to explain the disclosure, and cannot be understood as a limitation on the disclosure. Based on the embodiments of the disclosure, all other embodiments obtained by a person of ordinary skill in the art without creative efforts fall within the protection scope of the disclosure. The following describes the embodiments of the disclosure in detail with reference to the accompanying drawings.

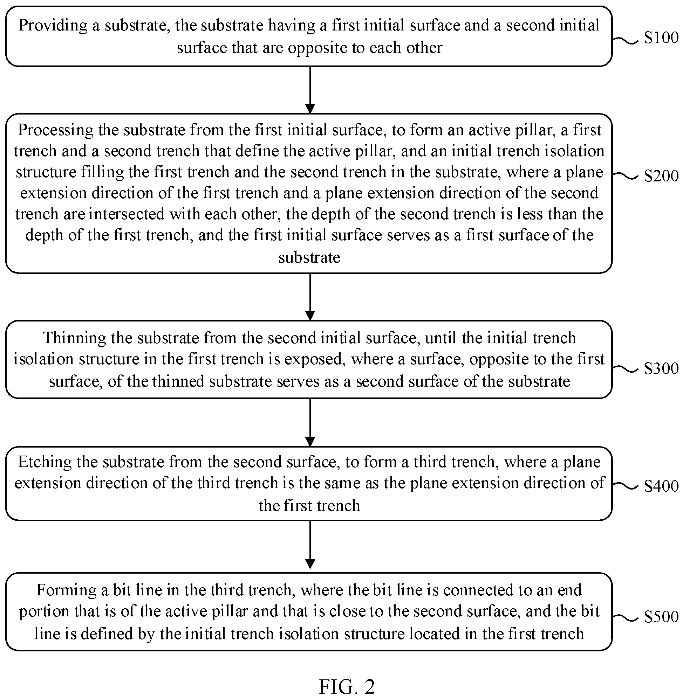

According to a first aspect, the disclosure provides a method for manufacturing a semiconductor structure. FIG. 2 is a schematic flowchart of a method for manufacturing a semiconductor structure according to an embodiment of the disclosure. As shown in FIG. 2, for example, the manufacturing method includes the steps as follows.

In the step of S100, a substrate is provided. The substrate has a first initial surface and a second initial surface that are opposite to each other.

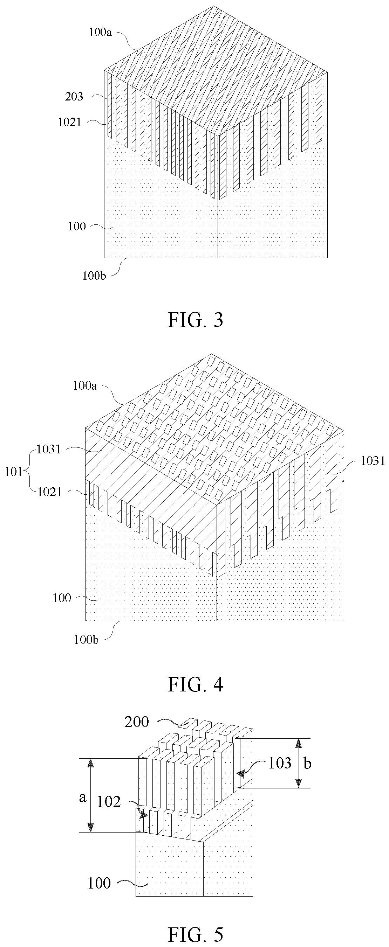

FIG. 3 is a schematic structural diagram of forming a first isolation layer 1021 in a substrate 100 of a semiconductor structure according to an embodiment of the disclosure. As shown in FIG. 3, the substrate 100 may be made of monocrystalline silicon, polysilicon, amorphous silicon, a silicon-germanium compound, silicon on insulator (SOI), or another material known to a person skilled in the art. The substrate 100 may be a structural basis supporting a trench isolation structure 101, a bit line 300, and a word line 400 that are disposed subsequently. The substrate 100 may be formed through deposition, e.g., chemical vapor deposition (CVD), physical vapor deposition (PVD), or atomic layer deposition (ALD).

In a thickness direction of the substrate 100, the substrate 100 may include a first initial surface 100a and a second initial surface 100b that are opposite to each other. For example, in a direction shown in FIG. 3, the top surface of the substrate 100 is the first initial surface 100a, and the bottom surface is the second initial surface 100b.

In the step of S200, the substrate is processed from the first initial surface, to form an active pillar, a first trench and a second trench that define the active pillar, and an initial trench isolation structure filling the first trench and the second trench in the substrate. A plane extension direction of the first trench and a plane extension direction of the second trench are intersected with each other, the depth of the second trench is less than the depth of the first trench, and the first initial surface serves as a first surface of the substrate.

For example, in this embodiment of the disclosure, a method for forming the first trench 102 and the second trench 103 in the substrate 100 may include the implementations as follows.

In a first feasible implementation, that the substrate 100 is processed from the first initial surface 100a includes the step as follows. The substrate 100 is patterned from the first initial surface 100a, to form the first trench 102 and an active strip 203 defined by the first trench 102. The first trench 102 may extend in a first direction. For a structure of the active strip 203, refer to FIG. 3. The first isolation layer 1021 is filled in the first trench 102. A material of the first isolation layer 1021 may be silicon oxide, silicon nitride, silicon oxynitride, or the like. The first isolation layer 1021 fills the first trench 102, and is located between adjacent active strips 203, to effectively isolate the active strips 203.

After the active strip 203 is formed, the step as follows is further included. The first isolation layer 1021 and the active strip 203 are patterned from the first initial surface 100a, to form the second trench 103 and an active pillar 200. FIG. 4 is a schematic structural diagram of forming a first isolation layer and a second isolation layer in a substrate of a semiconductor structure according to an embodiment of the disclosure. FIG. 5 is a schematic structural diagram of forming an active pillar in a substrate of a semiconductor structure according to an embodiment of the disclosure. With reference to FIG. 4 and FIG. 5, the second trench 103 extends in a second direction, and the first direction and the second direction are intersected with each other. The depth of the first trench 102 may be *a* as shown in FIG. 5, the depth of the second trench 103 may be *b* as shown in FIG. 5, and *a* is greater than *b.* The first trench 102 and the second trench 103 define the active pillar 200, and active pillars 200 are arranged in an array. The depth *a* of the first trench 102 may range from 150 nm to 200 nm, and the depth of the second trench 103 may range from 100 nm to 150 nm.

After the second trench 103 is formed, the step as follows is further included. A second isolation layer 1031 is filled in the second trench 103. The first trench 102 and the second trench 103 are communicated with each other, and the initial trench isolation structure includes the first isolation layer 1021 retained in the first trench 102 and the second isolation layer 1031 located in the second trench 103. A material of the second isolation layer 1031 may be silicon oxide, silicon nitride, silicon oxynitride, or the like, and the second isolation layer 1031 may isolate adjacent active pillars 200.

The first isolation layer 1021 is filled in the first trench 102, to form a first trench isolation structure. The second isolation layer 1031 is filled in the second trench 103, to form a second trench isolation structure. The first trench isolation structure and the second trench isolation structure may jointly form the trench isolation structure 101.

In a feasible implementation, the material of the first isolation layer 1021 and the material of the second isolation layer 1031 are the same. In this way, manufacturing difficulty of the trench isolation structure 101 can be effectively reduced. Certainly, in some embodiments, the material of the first isolation layer 1021 and the material of the second isolation layer 1031 may alternatively be set to be different according to a requirement.

In a second feasible implementation, that the substrate 100 is processed from the first initial surface 100a includes the step as follows. A mask layer is formed on the first initial surface 100a of the substrate 100. The mask layer has a first opening and a second opening that are communicated with each other, an extension direction of the first opening and an extension direction of the second opening are intersected with each other, and the width of the first opening is greater than the width of the second opening.

It should be noted that the first opening may extend in the first direction, and the second opening may extend in the second direction. The substrate 100 is etched along the first opening and the second opening, to form the first trench 102 corresponding to the first opening and the second trench 103 corresponding to the second opening. The width of the first opening is greater than the width of the second opening. In an etching process, because of an etching loading effect, the depth of the formed first trench 102 is relatively large, and the depth of the second trench 103 is relatively small.

After the first trench 102 and the second trench 103 are formed, the step as follows is further included. An isolation material is filled in the first trench 102 and the second trench 103, to form the initial trench isolation structure. The isolation material may be silicon oxide, silicon nitride, silicon oxynitride, or the like. The isolation material filled in the first trench 102 forms the first trench isolation structure, and the isolation material filled in the second trench 103 forms the second trench isolation structure. In some embodiments, the isolation material filled in the first trench 102 and the isolation material filled in the second trench 103 may alternatively be set to be different according to a requirement.

For example, the method for manufacturing a semiconductor structure further includes the step as follows. A vertical channel transistor is formed based on the active pillar 200. It should be noted that in this embodiment of the disclosure, the active pillar 200 extends in a direction perpendicular to the substrate 100, and a transistor formed based on the active pillar 200 is a vertical channel transistor. There may be the following two implementations in which the vertical channel transistor is formed based on the active pillar 200.

In a first feasible implementation, that a vertical channel transistor is formed based on the active pillar 200 includes the step as follows. The initial trench isolation structure is etched from the first surface 100c, to form a fourth trench. A depth of the fourth trench is less than the depth of the second trench 103, and a plane extension direction of the fourth trench is intersected with the first direction.

The word line 400 is formed in the fourth trench. The word line 400 covers a partial sidewall of the active pillar 200. An isolation material is filled in the fourth trench in which the word line 400 is formed, to form a filling layer. The vertical channel transistor includes the active pillar 200 and the word line 400. For example, the plane extension direction of the fourth trench is the same as the plane extension direction of the second trench 103.

It should be noted that the initial trench isolation structure is etched from the first surface 100c, to form the fourth trench. For example, the fourth trench may be located on one side of the active pillar 200, and the active pillar 200 is not exposed by the fourth trench; or the fourth trench may be located on one side of the active pillar 200, and the active pillar 200 may be exposed by the fourth trench in a partial plane direction; or the active pillar 200 is located in the fourth trench, and the active pillar 200 may be exposed by the fourth trench in any plane direction. The word line 400 is formed in the fourth trench, and in an extension direction of the active pillar 200, a channel region 200c is formed at a middle position in the extension direction of the active pillar 200, and a source region and a drain region are respectively formed at two ends of the extension direction of the active pillar 200. Therefore, the fourth trench corresponds to the middle position in the extension direction of the active pillar 200, and the depth of the fourth trench is less than the depth of the second trench 103. The extension direction of the fourth trench is an extension direction of the subsequently formed word line 400. To ensure that the plane extension direction of the word line 400 and a plane extension direction of the bit line 300 are intersected with each other, the plane extension direction of the fourth trench and the plane extension direction of the bit line 300 are intersected with each other.

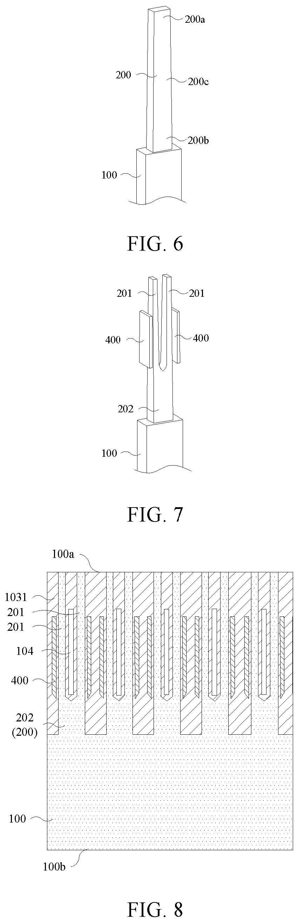

FIG. 6 is a schematic structural diagram of an active pillar of a semiconductor structure according to an embodiment of the disclosure. FIG. 6 shows a structure of a single active pillar 200. The word line 400 may cover at least a partial sidewall of the active pillar 200, to form the vertical channel transistor.

A material of the word line 400 may be tungsten, and the word line 400 is formed in the fourth trench through deposition. It should be explained that active pillars 200 are on two sides of the second trench 103. Therefore, two fourth trenches corresponding to the active pillars 200 on the two sides may be formed in the second trench 103, and two word lines 400 are respectively formed in the two fourth trenches, and respectively correspond to the two active pillars 200. An isolation material is filled in the fourth trench in which the word line 400 is formed. The isolation material may be silicon oxide, silicon nitride, silicon oxynitride, or the like. The isolation material may be filled in the fourth trench through deposition. The isolation material may ensure structural stability of the word line 400 and stability of signal transmission in the word line 400.

A manner in which the word line 400 covers the active pillar 200 may include the following implementations. In a first feasible implementation, one word line 400 may cover only one side of the channel region 200c of the active pillar 200, to form a single-sided gate structure of the vertical channel transistor. In a second feasible implementation, one word line 400 may cover two sides of the channel region 200c of the active pillar 200, to form a dual-sided gate structure of the vertical channel transistor. In a third feasible implementation, one word line 400 may surround a periphery of the channel region 200c of the active pillar 200, to form a gate-partially-around structure or a gate-all-around structure of the vertical channel transistor.

It should be noted that, in the case where the active pillar 200 is not exposed by the fourth trench, a trench wall of the fourth trench may be of an initial trench isolation structure of a specific thickness, and the word line 400 and the channel region 200c of the active pillar 200 may be isolated by the initial trench isolation structure on the trench wall of the fourth trench, to form a gate dielectric layer of the vertical channel transistor (that is, the gate dielectric layer does not need to be specifically formed). In this way, a gate control capability of the vertical channel transistor can be effectively ensured, and a control capability of the vertical channel transistor for signal transmission in the semiconductor structure is ensured. Certainly, when the active pillar 200 is exposed by the fourth trench, the gate dielectric layer needs to be specifically formed when the word line 400 is formed. In a second feasible implementation, that a vertical channel transistor is formed based on the active pillar 200 includes the steps as follows. The initial trench isolation structure located in the second trench 103 is etched from the first surface 100c, to form a fifth trench. The depth of the fifth trench is less than the depth of the second trench 103, and a plane extension direction of the fifth trench is the same as the plane extension direction of the second trench 103.

The word line 400 is formed in the fifth trench. The word line 400 covers a partial sidewall of the active pillar 200, and each active pillar 200 corresponds to two word lines 400. An isolation material is filled in the fifth trench in which the word line 400 is formed, to form a filling layer.

The active pillar 200 and the initial trench isolation structure are etched from the first surface 100c, to form a sixth trench. The depth of the sixth trench is less than the depth of the second trench 103, a plane extension direction of the sixth trench being the same as the plane extension direction of the second trench 103, and the sixth trench divides the active pillar 200 into two active sub-pillars 201 and a connecting portion 202 connecting the two active sub-pillars 201. A dielectric layer is filled in the sixth trench, and an air gap 104 is formed. The vertical channel transistor includes one active sub-pillar 201 and one word line 400.

It should be noted that the initial trench isolation structure is etched from the first surface 100c, to form the fifth trench. The second trench isolation structure in the second trench 103 may be etched, to form the fifth trench in the second trench 103. Similar to the fourth trench, the word line 400 is formed in the fifth trench. Therefore, the fifth trench corresponds to the channel region 200c of the active pillar 200, and the depth of the fifth trench is less than the depth of the second trench 103. In addition, the plane extension direction of the word line 400 may be a plane extension direction of a fifth trench. Therefore, the plane extension direction of the fifth trench and the plane extension direction of the bit line 300 are intersected with each other. A specific material and a function of the isolation material filled in the fifth trench are the same as those of the isolation material filled in the fourth trench. Details are not described herein again.

After the fifth trench is formed, the active pillar 200 and the initial trench isolation structure are etched from the first surface 100c. In this case, the first trench isolation structure is etched, to form the sixth trench, and the sixth trench divides the active pillar 200 into the two active sub-pillars 201. The depth of the sixth trench is less than the depth of the second trench 103. In this way, the sixth trench may be prevented from cutting off the active pillar 200 in the extension direction of the active pillar 200 through etching, to ensure that the active pillar 200 with a partial extended length is retained at end portions of the two active sub-pillars 201, so as to form a connecting portion 202 connecting the two active sub-pillars 201.

The dielectric layer is filled in the sixth trench through deposition. A material of the dielectric layer may be silicon oxide, silicon nitride, or silicon oxynitride. The material of the dielectric layer may be the same as the material of the isolation material, the material of the first isolation layer 1021, and the material of the second isolation layer 1031. In this way, manufacturing difficulty of the semiconductor structure can be reduced. In a deposition process of the dielectric layer, a deposition process parameter of the dielectric layer may be controlled, to form the air gap 104 in the sixth trench. The air gap 104 may improve an effect of isolation between the two active sub-pillars 201, to avoid or reduce electrical interference between the active sub-pillars 201.

FIG. 7 is a schematic structural diagram of another active pillar of a semiconductor structure according to an embodiment of the disclosure. FIG. 8 is a cross-sectional view of forming an active pillar in a substrate of a semiconductor structure according to an embodiment of the disclosure. The cross-sectional view shown in FIG. 8 is a cross-sectional view in the extension direction of the first trench 102 in FIG. 7. A subsequent cross-sectional view is a cross-sectional view in the extension direction of the first trench 102. FIG. 7 and FIG. 8 show structures of the active pillar 200 with the air gap 104 and the word line 400. Two word lines 400 respectively cover at least partial sidewalls of the two active sub-pillars 201, to form two vertical channel transistors.

In this implementation, one active sub-pillar 201 and one word line 400 form a vertical trench transistor. The subsequently formed bit line 300 is connected to the connecting portion 202, and the two active sub-pillars 201 are respectively connected to subsequently formed different storage structures 600. In a signal transmission process of the semiconductor structure, the bit line 300 inputs signals to the two active sub-pillars 201 through the connecting portion 202, and the word lines 400 corresponding to the two active sub-pillars 201 respectively control conduction and cutoff of the two active sub-pillars 201, to control the two active sub-pillars 201 to separately store signals in different storage structures 600 or read signals from different storage structures 600. In this way, a signal storage capability and signal transmission efficiency of the semiconductor structure can be effectively improved.

The vertical channel transistor is formed based on the active pillar 200, and the active pillar 200 includes the source region, the drain region, and the channel region 200c. As shown in the foregoing descriptions, the word line 400 covers the outside of the channel region 200c of the active pillar 200. The source region and the drain region are respectively formed on two sides of the channel region 200c of the active pillar 200, and a formation process may include the step as follows. After the initial trench isolation structure is formed, an end portion that is of the active pillar 200 and that is exposed by the first surface 100c is doped from the first surface 100c, to form a first doped region 200a. The end portion that is of the active pillar 200 and that is exposed by the first surface 100c may be a first end of the active pillar 200, and the first doped region 200a formed at the first end may be one of the source region and the drain region of the active pillar 200.

Before the bit line 300 is subsequently formed, an end portion that is of the active pillar 200 and that is close to the second surface 100d is doped from the second surface 100d, to form a second doped region 200b. The end portion that is of the active pillar 200 and that is close to the second surface 100d may be a second end opposite to the first end, and the second doped region 200b formed at the second end may be the other one of the source region and the drain region of the active pillar 200.

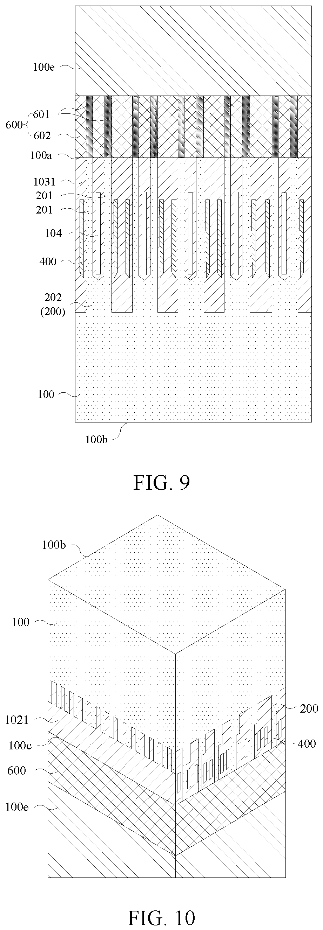

The method for manufacturing a semiconductor structure further includes the step as follows. The storage structure 600 is formed. The storage structure 600 is located on the first surface 100c of the substrate 100, and the storage structure 600 is coupled to the vertical channel transistor. FIG. 9 is a cross-sectional view of forming a storage structure and an auxiliary substrate on a substrate of a semiconductor structure according to an embodiment of the disclosure. As shown in FIG. 9, the storage structure 600 may be located on the first surface 100c of the substrate 100. In other words, in a direction shown in FIG. 9, the storage structure 600 is located on the top of the substrate 100 with the vertical channel transistor.

The storage structure 600 may be a capacitor, or may be a magnetic tunnel junction (MTJ). A specific type of the storage structure 600 is not limited in the disclosure. An example in which the storage structure 600 is a capacitor is utilized for description in this embodiment of the disclosure. The capacitor may include multiple capacitors 601. The multiple capacitors 601 are arranged in an array. A capacitor isolation layer 602 made of an insulating material is disposed between adjacent capacitors 601. The capacitor isolation layer 602 may prevent electrical interference between the adjacent capacitors 601.

On the basis that the first end of the active pillar 200 is exposed on the first surface 100c of the substrate 100, after the capacitor is formed on the first surface 100c, the first end of the active pillar 200 may be coupled to the capacitor. For example, one active sub-pillar 201 of the active pillar 200 is correspondingly connected to one capacitor, and a vertical channel transistor formed based on the active sub-pillar 201 may control signal input or signal reading of the corresponding connected capacitor.

Still as shown in FIG. 9, an auxiliary substrate 100e may be formed on the top of the storage structure 600, and the auxiliary substrate 100e may have a support effect. When the second surface 100d of the substrate 100 is subsequently processed, the auxiliary substrate 100e may support the substrate 100 and the vertical channel transistor in the substrate 100. It should be noted that a material of the auxiliary substrate 100e may be the same as a material of the substrate 100, to reduce complexity of a manufacturing process of the semiconductor structure. The thickness of the auxiliary substrate 100e may be set according to a requirement. This is not limited in the disclosure.

After the vertical channel transistor is formed, the step as follows is further included. The bit line 300 is formed. A specific method for forming the bit line 300 includes the step as follows. In the step of S300, the substrate is thinned from the second initial surface, until the initial trench isolation structure in the first trench is exposed. A surface, opposite to the first surface, of the thinned substrate serves as the second surface of the substrate.

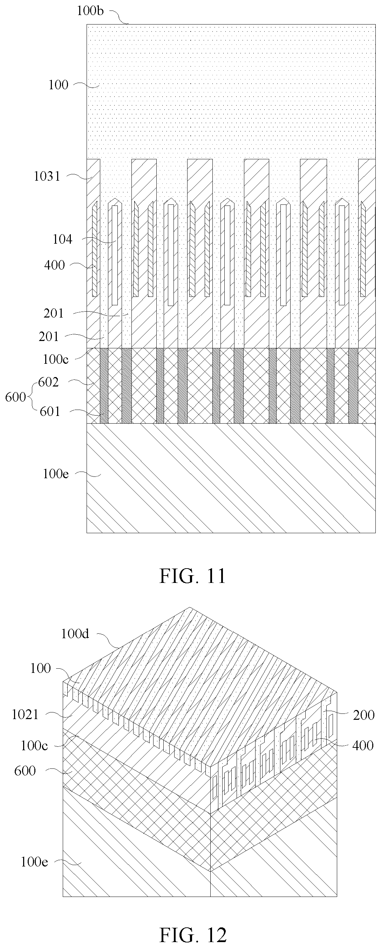

FIG. 10 is a schematic structural diagram of a semiconductor structure with a substrate flipped over according to an embodiment of the disclosure. FIG. 11 is a cross-sectional view of a semiconductor structure with a substrate flipped over according to an embodiment of the disclosure. As shown in FIG. 10 and FIG. 11, before the second initial surface 100b is processed, the substrate 100 may be flipped over, so that the second initial surface 100b of the substrate 100 is located on the top surface of the substrate 100. In this way, difficulty in processing the second initial surface 100b can be reduced. That is, directions of structures shown in FIG. 10 and FIG. 11 are directions obtained after a structure shown in FIG. 9 is turned upside down.

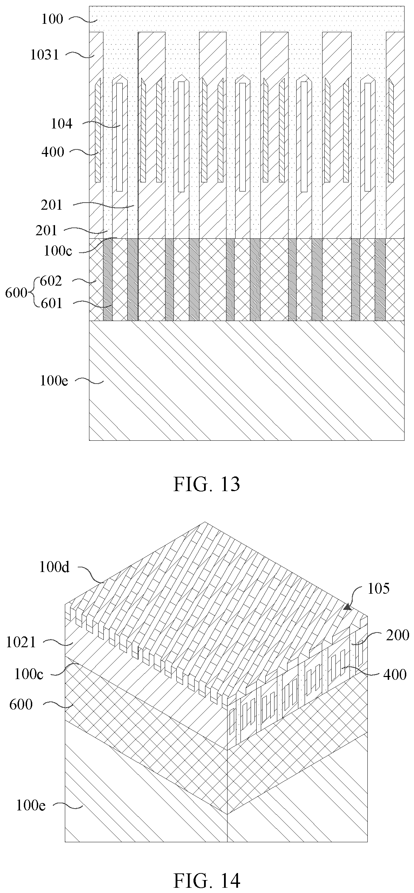

FIG. 12 is a schematic structural diagram of a semiconductor structure with a substrate thinned according to an embodiment of the disclosure. FIG. 13 is a cross-sectional view of a semiconductor structure with a substrate thinned according to an embodiment of the disclosure. As shown in FIG. 12 and FIG. 13, the second initial surface 100b is thinned. Such processing may be completed with a chemical mechanical polishing (CMP) process. On a basis that the depth of the first trench 102 is greater than the depth of the second trench 103 before the substrate 100 is flipped over, after the substrate 100 is flipped over, the first trench 102 is exposed before the second trench 103 in a process of thinning the second surface 100d of the substrate 100, and correspondingly, the first isolation layer 1021 in the first trench 102 is also exposed. The top surface of the thinned substrate 100, namely, a surface opposite to the first surface 100c forms the second surface 100d of the substrate 100.

In the step of S400, the substrate is etched from the second surface, to form a third trench. A plane extension direction of the third trench is the same as the plane extension direction of the first trench.

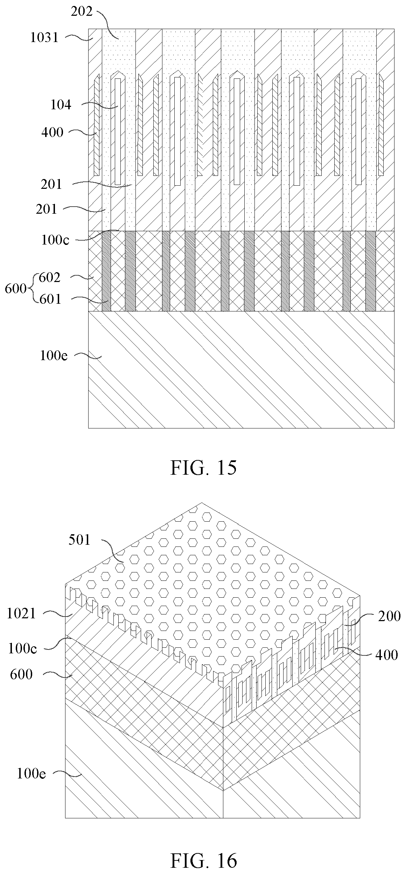

FIG. 14 is a schematic structural diagram of forming a third trench in a semiconductor structure according to an embodiment of the disclosure. FIG. 15 is a cross-sectional view of forming a third trench in a semiconductor structure according to an embodiment of the disclosure. As shown in FIG. 14 and FIG. 15, the substrate 100 of a partial thickness between adjacent first trenches 102 is removed, to form the third trench 105. The first trench 102 and the second trench 103 define the active pillar 200. Therefore, both the first trench 102 and the second trench 103 expose a part of the active pillar 200. Based on this, the depth of the third trench 105 may be relatively large, to ensure that the third trench 105 may expose the second trench 103 and the second isolation layer 1031 in the second trench 103. The depth of the third trench 105 may alternatively be relatively small, to ensure that the third trench 105 exposes only the first trench 102 and the first isolation layer 1021 in the first trench 102. Both the foregoing two depths of the third trench 105 can ensure that the third trench 105 exposes the active pillar 200. The plane extension direction of the third trench 105 is parallel to the plane extension direction of the first trench 102, and the third trench 105 is located between the adjacent first trenches 102.

After the third trench 105 is formed, the bit line 300 is formed in the third trench 105. For example, before the bit line 300 is formed, the step as follows is further included. A bit line contact structure 500 is formed. The bit line contact structure 500 is configured to connect the second doped region 200b of the active pillar 200 and the bit line 300.

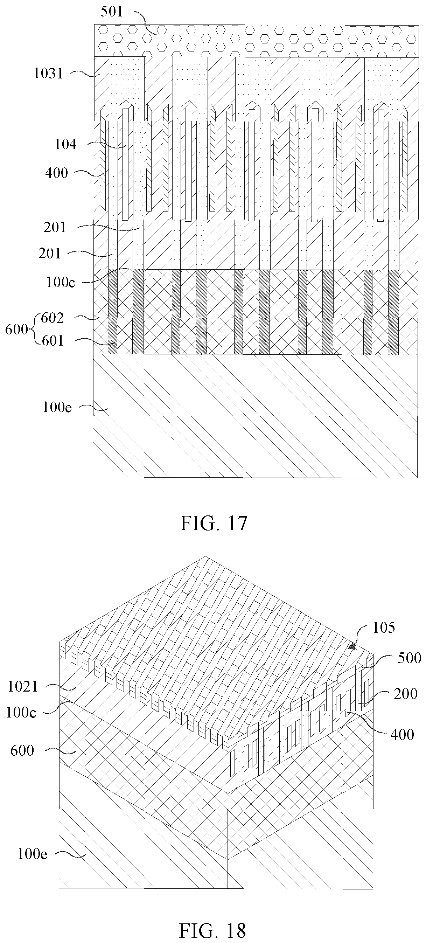

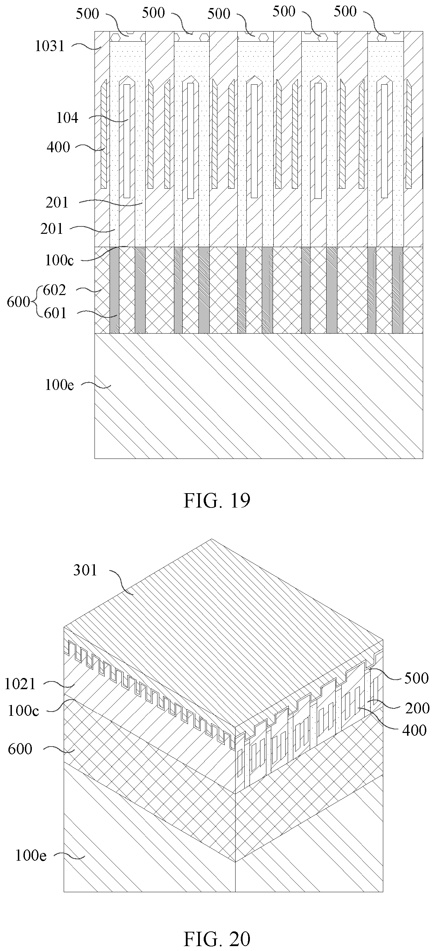

FIG. 16 is a schematic structural diagram of forming a contact material in a semiconductor structure according to an embodiment of the disclosure. FIG. 17 is a cross-sectional view of forming a contact material in a semiconductor structure according to an embodiment of the disclosure. As shown in FIG. 16 and FIG. 17, that the bit line contact structure 500 is formed includes the step as follows. A contact material 501 is deposited in the third trench 105. The contact material 501 may be cobalt. After the contact material 501 is formed, the contact material 501 and the substrate 100 react through heat treatment. For example, the substrate 100 is silicon, and the contact material 501 is cobalt. Cobalt and silicon react through heat treatment, to generate a cobalt-silicon compound. The cobalt-silicon compound may be utilized to effectively reduce contact resistance between the subsequent bit line 300 and the active pillar 200. FIG. 18 is a schematic structural diagram of forming a bit line contact structure in a semiconductor structure according to an embodiment of the disclosure. FIG. 19 is a cross-sectional view of forming a bit line contact structure in a semiconductor structure according to an embodiment of the disclosure. As shown in FIG. 18 and FIG. 19, the cobalt-silicon compound forms the bit line contact structure 500.

After the bit line contact structure 500 is formed, the step as follows is further included. In the step of S500, the bit line is formed in the third trench. The bit line is connected to the end portion that is of the active pillar and that is close to the second surface, and the bit line is defined by the initial trench isolation structure located in the first trench.

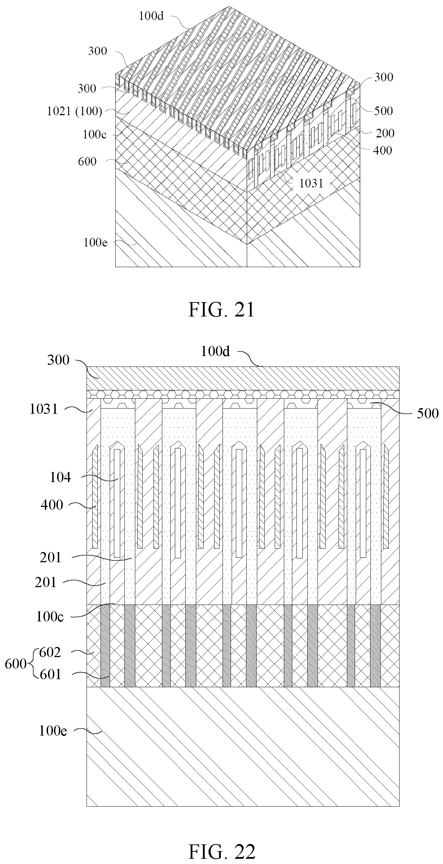

FIG. 20 is a schematic structural diagram of forming a bit line material in a semiconductor structure according to an embodiment of the disclosure. FIG. 21 is a schematic structural diagram of forming a bit line in a semiconductor structure according to an embodiment of the disclosure. FIG. 22 is a cross-sectional view of forming a bit line in a semiconductor structure according to an embodiment of the disclosure. As shown in FIG. 20 and FIG. 21, the bit line 300 may be formed through deposition. In the third trench 105 in which the bit line contact structure 500 is formed, a bit line material 301 is deposited, and the bit line material 301 may be at least one of titanium nitride and tungsten. The bit line material 301 may completely cover the second surface 100d of the substrate 100, and is filled in the third trench 105. For a structure of the bit line material 301, refer to FIG. 20. After the bit line material 301 is deposited, a bit line material 301 outside the third trench 105 is removed with the CMP process or an etching back process, the bit line material 301 located in the third trench 105 is retained, and the bit line 300 is formed. For a structure of the bit line 300, refer to FIG. 21 and FIG. 22. In this embodiment of the disclosure, for example, the bit line material 301 includes titanium nitride and tungsten. The formed bit line 300 includes a titanium nitride layer and a tungsten layer.

On a basis that the third trench 105 may expose the active pillar 200, the third trench 105 is located between adjacent first trenches 102. Therefore, the bit line 300 is formed in the third trench 105, and the bit line 300 may be defined by the first trench 102. In this way, it can be ensured that the bit line 300 and the active pillar 200 are precisely aligned, to reduce difficulty in alignment between the bit line 300 and the active pillar 200, and improve precision of alignment between the bit line 300 and the active pillar 200, thereby helping improve an effect of signal transmission between the bit line 300 and the active pillar 200.

According to a second aspect, the disclosure provides a semiconductor structure. The semiconductor structure may be manufactured through the foregoing method for manufacturing a semiconductor structure. The semiconductor structure includes a substrate 100, an active pillar 200, a bit line 300, and a trench isolation structure 101. The substrate 100 has a first surface 100c and a second surface 100d that are opposite to each other. The trench isolation structure 101 is located in the substrate 100, the trench isolation structure 101 includes a first trench isolation structure and a second trench isolation structure that extend from the first surface 100c to the second surface 100d, the first trench isolation structure is exposed by the first surface 100c and the second surface 100d, and the second trench isolation structure is exposed by the first surface 100c.

The active pillar 200 is defined by the first trench isolation structure and the second trench isolation structure, a first end of the active pillar 200 is exposed by the first surface 100c, a second end of the active pillar 200 is opposite to the first end, and the second end is connected to the bit line 300. The bit line 300 is defined by the first trench isolation structure, a plane extension direction of the bit line 300 is the same as a plane extension direction of the first trench isolation structure, and the bit line 300 is exposed by the second surface 100d.

As shown in FIG. 21 and FIG. 22, the active pillar 200, the bit line 300, and a word line 400 in the disclosure may be located in the substrate 100, and the substrate 100 may provide a structural basis for the active pillar 200, the bit line 300, and the word line 400. The active pillar 200 may be defined by the first trench isolation structure and the second trench isolation structure, and the first trench isolation structure and the second trench isolation structure can effectively isolate adjacent active pillars 200, to ensure stability of electrical signal transmission in the active pillar 200. In addition, the first trench isolation structure and the second trench isolation structure may support the active pillar 200 from sidewalls of the active pillar 200, to prevent the active pillar 200 from being tilted or collapsed during manufacturing and utilization, thereby improving structural stability of the active pillar 200.

The first trench isolation structure is exposed by the first surface 100c and the second surface 100d of the substrate 100 that are opposite to each other, and the second trench isolation structure is exposed by the first surface 100c. The first end of the active pillar 200 is exposed on the first surface 100c. Therefore, the first end of the active pillar 200 is defined by the first trench isolation structure and the second trench isolation structure. The second end of the active pillar 200 extends to the second surface 100d, and the bit line 300 is located on the second surface 100d of the substrate 100, and is defined by the first trench isolation structure. The bit line 300 is connected to the second end of the active pillar 200. On a basis that the second end of the active pillar 200 and the bit line 300 are jointly defined by the first trench isolation structure, difficulty in alignment between the bit line 300 and the active pillar 200 is effectively reduced, and precision of alignment between the bit line 300 and the active pillar 200 is improved, to ensure electrical signal transmission between the bit line 300 and the active pillar 200.

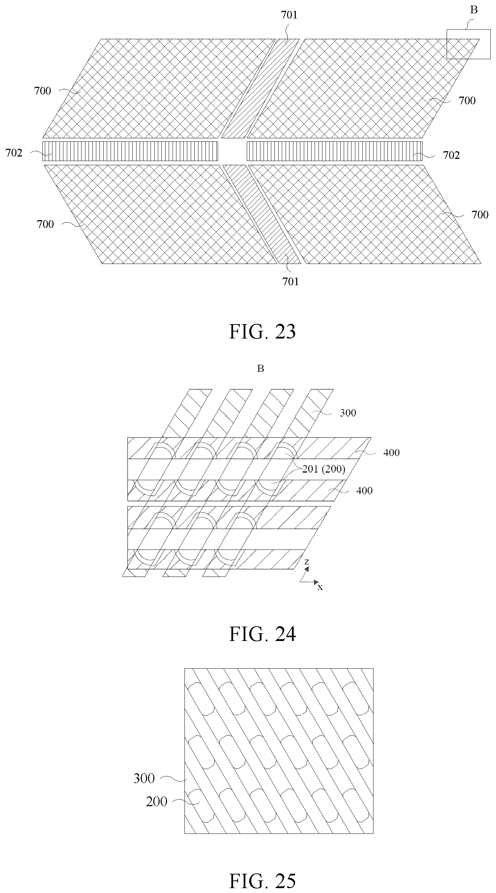

In some embodiments, the semiconductor structure further includes a storage structure 600. The storage structure 600 is located on the first surface 100c of the substrate 100, and the storage structure 600 is coupled to a vertical channel transistor. The semiconductor structure provided in the disclosure forms a memory array 700, and multiple memory arrays 700 jointly form a memory. The following describes a structure of the memory array 700. FIG. 23 is a schematic structural diagram of a memory array formed based on a semiconductor structure according to an embodiment of the disclosure. FIG. 24 is a partially enlarged view of a portion B in FIG. 23. FIG. 25 is a schematic structural diagram of a bit line and an active pillar of a semiconductor structure according to an embodiment of the disclosure.

As shown in FIG. 23 to FIG. 25, a substrate 100 of each memory array 700 in this embodiment of the disclosure includes multiple active pillars 200 and multiple storage structures 600. The multiple active pillars 200 are arranged in an array in the substrate 100, the multiple storage structures 600 are arranged in an array on the substrate 100, and the multiple storage structures 600 and the multiple active pillars 200 are coupled in one-to-one correspondence. The memory array 700 further includes multiple word lines 400 and multiple bit lines 300, plane extension directions of the multiple word lines 400 are parallel to each other, plane extension directions of the multiple bit lines 300 are parallel to each other, and the plane extension direction of the word line 400 and the plane extension direction of the bit line 300 are intersected with each other. One bit line 300 is connected to second ends of the multiple active pillars 200, and one word line 400 corresponds to channel regions 200c of active sub-pillars 201 of the multiple active pillars 200.

As shown in FIG. 23, the multiple memory arrays 700 provided in this embodiment of the disclosure may jointly form the memory, and the multiple memory arrays 700 are arranged in an array. In the plane extension direction of the word line 400, a sub-word line driver 701 is disposed between two adjacent memory arrays 700, and the sub-word line driver circuit 701 is connected to word lines 400 of the corresponding adjacent memory arrays 700, and is configured to drive the word line 400. In the plane extension direction of the bit line 300, a sense amplifier 702 is disposed between two adjacent memory arrays 700, and the sense amplifier 702 is connected to bit lines 300 of the corresponding adjacent memory arrays 700, and is configured to process an electrical signal on the bit line 300.

As shown in FIG. 24, in this embodiment of the disclosure, the active pillars 200 are arranged in a hexagonal close-packed form, and the storage structures 600 may have the same arrangement manner as the active pillars 200, to not only reduce difficulty in connecting the storage structure 600 and the active pillar 200, but also reduce manufacturing difficulty of the semiconductor structure. In addition, a hexagonal close-packed arrangement manner can effectively improve arrangement density of the storage structure 600, thereby improving a storage amount of the semiconductor structure and helping improve storage performance of the semiconductor structure. It should be noted that FIG. 24 shows the active pillar 200, or may show a storage node contact structure of the active pillar 200.

Still as shown in FIG. 24, in this embodiment of the disclosure, the plane extension direction of the bit line 300 is a direction z shown in FIG. 24, the plane extension direction of the word line 400 is a direction x shown in FIG. 24, and an included angle between the bit line 300 and the word line 400 ranges from 20° to 90°. In some embodiments, the included angle between the bit line 300 and the word line 400 may be 30°, 60°, or 75°. A specific value of the included angle is not limited in the disclosure. For example, the included angle between the bit line 300 and the word line 400 may be 60°, so that the storage structure 600 is set to be in a hexagonal close-packed form.

As shown in FIG. 25, on a basis that both the second end of the active pillar 200 and the bit line 300 are defined by the first trench isolation structure, and a plane extension direction of the second end of the active pillar 200 and the plane extension direction of the bit line 300 are the same. An orthographic projection of the second end of the active pillar 200 in a plane in which the bit line 300 is located may be covered by the bit line 300. In this way, precision of alignment between the active pillar 200 and the bit line 300 can be effectively improved, and an effect of alignment between the active pillar 200 and the bit line 300 is ensured.

With reference to FIG. 1, FIG. 24, and FIG. 25, compared with a related technology, the disclosure has the advantages as follows. The disclosure can reduce a quantity of bit lines 300 while ensuring stable signal transmission of the active pillar 200. In this way, manufacturing difficulty of the bit line 300 can be reduced, and adjacent bit lines 300 are prevented from being short-circuited. In addition, the width of a single bit line 300 is prevented from being too small, to help reduce parasitic capacitance of the bit line 300, avoid excessive contact resistance between the bit line 300 and the active pillar 200, and improve an effect of electric signal transmission between the bit line 300 and the active pillar 200, thereby ensuring storage performance of a memory including the semiconductor structure.

In this embodiment of the disclosure, for a structure of the active pillar 200, the following two implementations may be included.

In a first feasible implementation, as shown in FIG. 6, the active pillar 200 includes a first doped region 200a exposed by the first surface 100c, a second doped region 200b close to the second surface 100d, and a channel region 200c located between the first doped region 200a and the second doped region 200b.

In this implementation, the semiconductor structure further includes the word line 400. The word line 400 is located in the trench isolation structure 101, and covers the channel region 200c of the active pillar 200. The active pillar 200 and the word line 400 form the vertical channel transistor. The first doped region 200a may be one of a source region and a drain region of the vertical channel transistor, and the second doped region 200b may be the other one. The word line 400 covers the channel region 200c, and a gate dielectric layer may exist between the word line 400 and the channel region 200c, to ensure a gate control capability of the vertical channel transistor.

The plane extension direction of the word line 400 is the same as a plane extension direction of the second trench isolation structure. In this way, adjacent word lines 400 may be isolated by the second trench isolation structure, to avoid electrical interference between the adjacent word lines 400. In addition, the second trench isolation structure may support the word line 400, to avoid damage to a structure of the word line 400, and improve structural stability of the word line 400. In this embodiment of the disclosure, the active pillar 200 and the word line 400 may jointly form the vertical channel transistor, and a position relationship between the word line 400 and the active pillar 200 is adjusted, so that the vertical channel transistor forms a single-sided gate structure, a dual-sided gate structure, or a gate-all-around structure. A specific position relationship is described in detail in the foregoing embodiment of the method for manufacturing a semiconductor structure. Details are not described herein again.

In a second feasible implementation, with reference to FIG. 7 and FIG. 21, the active pillar 200 includes two active sub-pillars 201 and a connecting portion 202 connecting the two active sub-pillars 201, an air gap 104 is formed between the two active sub-pillars 201, and each active sub-pillar 201 includes a first doped region 200a exposed by the first surface 100c, a second doped region 200b close to the second surface 100d, and a channel region 200c located between the first doped region 200a and the second doped region 200b. In this implementation, the semiconductor structure further includes the word line 400. The word line 400 is located in the trench isolation structure 101, and covers the channel region 200c of the active sub-pillar 201. Each active sub-pillar 201 and one word line 400 form the vertical channel transistor.

It should be noted that the connecting portion 202 may be close to the second surface 100d of the substrate 100, form the second end of the active pillar 200, and is doped to form the second doped region 200b. The second doped region 200b may be one of a source region and a drain region of the active pillar 200, and the second doped region 200b is connected to the bit line 300. First ends that are of the two active sub-pillars 201 and that are close to the first surface 100c are doped to form first doped regions 200a, and the first doped region 200a may be the other one in the source region and the drain region of the active pillar 200. The first doped regions 200a of the two active sub-pillars 201 are separately connected to different storage structures 600. In this implementation, one active pillar 200 includes two active sub-pillars 201, and one active sub-pillar 201 corresponds to one word line 400 to form the vertical channel transistor. In this way, a quantity of vertical channel transistors in the semiconductor structure may be effectively improved, and storage performance of the memory including the semiconductor structure is improved.

The semiconductor structure in the disclosure further includes a bit line contact structure 500, and the bit line contact structure 500 is located between the active pillar 200 and the bit line 300, and connects the second end of the active pillar 200 and the bit line 300. The bit line contact structure 500 can effectively reduce contact resistance between the bit line 300 and the active pillar 200.

In some implementations, multiple bit line contact structures 500 connected to the same bit line 300 are discrete or integrated. Integrally disposed multiple bit line contact structures 500 may be simultaneously connected to multiple active pillars 200 corresponding to the same bit line 300, to effectively reduce manufacturing difficulty of the bit line contact structure 500, and ensure stability of connecting the multiple active pillars 200 and the same bit line 300. Separately disposed bit line contact structures 500 may be located in different third trenches 105 defined by the first trench isolation structure. When a bit line contact structure 500 at a joint of a specific active pillar 200 and the bit line 300 is adjusted, a connection between the retained active pillars 200 and the bit line 300 is not affected, so that structural flexibility of the bit line contact structure 500 can be improved.

According to a third aspect, the disclosure provides a memory. The memory may include the foregoing semiconductor structure. The memory may include a DRAM, a static random access memory (SRAM), a flash memory, an electrically erasable programmable read-only memory (EEPROM), a phase change random access memory (PRAM), or a magneto-resistive random access memory (MRAM).

Finally, it should be noted that the foregoing embodiments are merely intended for describing the technical solutions of the disclosure, but not for limiting the disclosure. Although the disclosure is described in detail with reference to the foregoing embodiments, persons of ordinary skill in the art should understand that they may still make modifications to the technical solutions described in the foregoing embodiments or make equivalent replacements to some or all technical features thereof. However, these modifications or replacements do not make the essence of the corresponding technical solutions depart from the scope of the technical solutions in the embodiments of the present disclosure.

## Claims

1. A semiconductor structure, comprising a substrate (100), an active pillar (200), a bit line (300), and a trench isolation structure (101);
wherein the substrate (100) has a first surface (100c) and a second surface (100d) that are opposite to each other;
the trench isolation structure (101) is located in the substrate (100), the trench isolation structure (101) comprises a first trench isolation structure and a second trench isolation structure that extend from the first surface (100c) to the second surface (100d), the first trench isolation structure is exposed by the first surface (100c) and the second surface (100d), and the second trench isolation structure is exposed by the first surface (100c);
the active pillar (200) is defined by the first trench isolation structure and the second trench isolation structure, a first end of the active pillar (200) is exposed by the first surface (100c), a second end of the active pillar (200) is opposite to the first end, and the second end is connected to the bit line (300); and
the bit line (300) is defined by the first trench isolation structure, a plane extension direction of the bit line (300) is the same as a plane extension direction of the first trench isolation structure, and the bit line (300) is exposed by the second surface (100d).

2. The semiconductor structure according to claim 1, wherein the active pillar (200) comprises a first doped region (200a) exposed by the first surface (100c), a second doped region (200b) close to the second surface (100d), and a channel region (200c) located between the first doped region (200a) and the second doped region (200b); and
the semiconductor structure further comprises a word line (400), the word line (400) is located in the trench isolation structure (101) and covers the channel region (200c) of the active pillar (200), and the active pillar (200) and the word line (400) form a vertical channel transistor.

3. The semiconductor structure according to claim 2, wherein the vertical channel transistor has a single-sided gate structure, a dual-sided gate structure, or a gate-all-around structure.

4. The semiconductor structure according to claim 1, wherein the active pillar (200) comprises two active sub-pillars (201) and a connecting portion (202) connecting the two active sub-pillars (201), an air gap (104) is formed between the two active sub-pillars (201), and each active sub-pillar (201) comprises a first doped region (200a) exposed by the first surface (100c), a second doped region (200b) close to the second surface (100d), and a channel region (200c) located between the first doped region (200a) and the second doped region (200b); and
the semiconductor structure further comprises a word line (400), the word line (400) is located in the trench isolation structure (101) and covers the channel region (200c) of the active sub-pillar (201), and each active sub-pillar (201) and one word line (400) form a vertical channel transistor.

5. The semiconductor structure according to claim 2 or 4, wherein a plane extension direction of the word line (400) is the same as a plane extension direction of the second trench isolation structure.

6. The semiconductor structure according to claim 2 or 4, wherein an included angle between the plane extension direction of the bit line (300) and a plane extension direction of the word line (400) ranges from 20° to 90°.

7. The semiconductor structure according to any one of claims 1 to 4, further comprising a bit line contact structure (500), wherein the bit line contact structure (500) is located between the active pillar (200) and the bit line (300), and connects the second end of the active pillar (200) and the bit line (300).

8. The semiconductor structure according to claim 7, wherein a plurality of the bit line contact structures (500) connected to a same bit line (300) are discrete or integrated.

9. The semiconductor structure according to any one of claims 2 to 4, further comprising a storage structure (600), wherein the storage structure (600) is located on the first surface (100c) of the substrate (100), and the storage structure (600) is coupled to the vertical channel transistor.

10. A method for manufacturing a semiconductor structure, comprising:
providing a substrate (100), wherein the substrate (100) has a first initial surface (100a) and a second initial surface (100b) that are opposite to each other;
processing the substrate (100) from the first initial surface (100a), to form an active pillar (200), a first trench (102) and a second trench (103) that define the active pillar (200), and an initial trench isolation structure filling the first trench (102) and the second trench (103) in the substrate (100), wherein a plane extension direction of the first trench (102) and a plane extension direction of the second trench (103) are intersected with each other, a depth of the second trench (103) is less than a depth of the first trench (102), and the first initial surface (100a) serves as a first surface (100c) of the substrate (100);
thinning the substrate (100) from the second initial surface (100b), until the initial trench isolation structure in the first trench (102) is exposed, wherein a surface, opposite to the first surface (100c), of the thinned substrate (100) serves as a second surface (100d) of the substrate (100);
etching the substrate (100) from the second surface (100d), to form a third trench (105), wherein a plane extension direction of the third trench (105) is the same as the plane extension direction of the first trench (102); and
forming a bit line (300) in the third trench (105), wherein the bit line (300) is connected to an end portion of the active pillar (200) close to the second surface (100d), and the bit line (300) is defined by the initial trench isolation structure located in the first trench (102).

11. The method for manufacturing a semiconductor structure according to claim 10, wherein the processing the substrate (100) from the first initial surface (100a) comprises:
patterning the substrate (100) from the first initial surface (100a), to form the first trench (102) and an active strip (203) defined by the first trench (102);
filling a first isolation layer (1021) in the first trench (102);
patterning the first isolation layer (1021) and the active strip (203) from the first initial surface (100a), to form the second trench (103) and the active pillar (200); and
filling a second isolation layer (1031) in the second trench (103),
wherein the first trench (102) and the second trench (103) are communicated with each other, and the initial trench isolation structure comprises the first isolation layer (1021) retained in the first trench (102) and the second isolation layer (1031) located in the second trench (103).

12. The method for manufacturing a semiconductor structure according to claim 11, wherein a material of the first isolation layer (1021) and a material of the second isolation layer (1031) are the same.

13. The method for manufacturing a semiconductor structure according to claim 10, wherein the processing the substrate (100) from the first initial surface (100a) comprises:
forming a mask layer on the first initial surface (100a) of the substrate (100), wherein the mask layer has a first opening and a second opening that are communicated with each other, an extension direction of the first opening and an extension direction of the second opening are intersected with each other, and a width of the first opening is greater than a width of the second opening;
etching the substrate (100) along the first opening and the second opening, to form the first trench (102) corresponding to the first opening and the second trench (103) corresponding to the second opening; and
filling an isolation material in the first trench (102) and the second trench (103), to form the initial trench isolation structure.

14. The method for manufacturing a semiconductor structure according to any one of claims 10 to 13, further comprising: forming a vertical channel transistor based on the active pillar (200).

15. The method for manufacturing a semiconductor structure according to claim 14, wherein the forming a vertical channel transistor based on the active pillar (200) comprises:
etching the initial trench isolation structure from the first surface (100c), to form a fourth trench, wherein a depth of the fourth trench is less than the depth of the second trench (103), and a plane extension direction of the fourth trench is intersected with a plane extension direction of the bit line (300);
forming a word line (400) in the fourth trench, the word line (400) covering a partial sidewall of the active pillar (200); and
filling an isolation material in the fourth trench in which the word line (400) is formed, to form a filling layer,
wherein the vertical channel transistor comprises the active pillar (200) and the word line (400).

16. The method for manufacturing a semiconductor structure according to claim 15, wherein the plane extension direction of the fourth trench is the same as the plane extension direction of the second trench (103).

17. The method for manufacturing a semiconductor structure according to claim 16, wherein the forming a vertical channel transistor based on the active pillar (200) comprises:
etching the initial trench isolation structure located in the second trench (103) from the first surface (100c), to form a fifth trench, wherein a depth of the fifth trench is less than the depth of the second trench (103), and a plane extension direction of the fifth trench is the same as the plane extension direction of the second trench (103);
forming a word line (400) in the fifth trench, wherein the word line (400) covers a partial sidewall of the active pillar (200), and each active pillar (200) corresponding to two word lines (400);
filling an isolation material in the fifth trench in which the word line (400) is formed, to form a filling layer;
etching the active pillar (200) and the initial trench isolation structure from the first surface (100c), to form a sixth trench, wherein a depth of the sixth trench is less than the depth of the second trench (103), a plane extension direction of the sixth trench is the same as the plane extension direction of the second trench (103), and the sixth trench divides the active pillar (200) into two active sub-pillars (201) and a connecting portion (202) connecting the two active sub-pillars (201); and
filling a dielectric layer in the sixth trench, and forming an air gap (104),
wherein the vertical channel transistor comprises one active sub-pillar (201) and one word line (400).

18. The method for manufacturing a semiconductor structure according to claim 14, wherein the forming a vertical channel transistor based on the active pillar (200) comprises: after the initial trench isolation structure is formed, doping, from the first surface (100c), an end portion of the active pillar (200) exposed by the first surface (100c), to form a first doped region (200a); and
before the bit line (300) is formed, doping, from the second surface (100d), an end portion of the active pillar (200) close to the second surface (100d), to form a second doped region (200b).

19. The method for manufacturing a semiconductor structure according to claim 18, further comprising: forming a bit line contact structure (500) before the bit line (300) is formed, wherein the bit line contact structure (500) connects the second doped region (200b) and the bit line (300).

20. The method for manufacturing a semiconductor structure according to claim 14, further comprising: forming a storage structure (600), wherein the storage structure (600) is located on the first surface (100c) of the substrate (100), and the storage structure (600) is coupled to the vertical channel transistor.
